# EUROPÄISCHE PATENTSCHRIFT

(11) **EP 2 602 934 B1**
(45) Veröffentlichungstag und Bekanntmachung des Hinweises auf die Patenterteilung: **30.08.2017**
(21) Anmeldenummer: 12188781.4
(22) Anmeldetag: 17.10.2012
(51) Int. Cl.: H03K 17/00

(54) **Halbleiterbaustein, Treiber, und Herstellungsverfahren**
Semiconductor module, driver, and manufacturing method
Module à semi-conducteur, pilote et procédé de fabrication

(30) Priorität: 05.12.2011 DE 102011087696
(43) Veröffentlichungstag der Anmeldung: 12.06.2013
(73) Patentinhaber: SEMIKRON Elektronik GmbH & Co. KG, 90431 Nürnberg (DE)
(72) Erfinder: Königsmann, Gunter, 91058 Erlangen (DE); Kalkmann, Bernhard, 91126 Schwabach (DE); Kobolla, Harald, 90556 Seukendorf (DE); Krapp, Johannes, 90491 Nürnberg (DE)

(56) Entgegenhaltungen:
- EP-A1- 0 503 401
- DE-T2- 69 637 318

## Beschreibung

Die Erfindung betrifft einen Halbleiterbaustein für einen, einen Leistungshalbleiterschalter ansteuernden Treiber, einen entsprechenden Treiber und ein Verfahren zur Herstellung eines Treibers.

Leistungshalbleiterschalter, beispielsweise IGBTs (insulated gate bipolar transistor) werden z.B. in leistungselektrischen Schaltungen, wie einem Umrichter einer Motorsteuerung eingesetzt. Sie werden in der Regel über einen potentialtrennenden Treiber an eine schaltsignalgebende Steuerlogik angeschlossen. In derartigen Treibern sind eine Vielzahl von Schalt-, Ansteuer-, Fehlerkontroll-, Logikfunktionen usw. realisiert. Hierzu werden in der Regel Halbleiterbausteine, insbesondere ASICs (application specific integrated circuit) eingesetzt. Die vom Treiber anzusteuernden Steuereingänge des Leistungshalbleiters befinden sich im Regelfall auf einem anderen Potential als die Steuerlogik, die die entsprechenden Schaltbefehle vorgibt.

Bekannte Treiber, insbesondere für IGBTs, sind sowohl in Varianten mit elektrisch als auch mit optisch übertragenen Ansteuersignalen verfügbar. Die letztgenannte optische Ansteuerung erfolgt also mit Licht, das als logische Information ein Steuersignal führt. Licht stellt für Leistungshalbleiter in vieler Hinsicht eine ideale Ansteuerungsform dar. Licht lässt sich nicht durch die hohen Spannungshübe in leistungselektronischen Systemen beeinflussen und stellt daher ein - zumindest theoretisch - idealelektrisch störsicheres Datenübertragungsmedium dar. Licht kann außerdem in Lichtwellenleitern über weite Entfernungen geführt werden, ohne dass Störeinkopplungen zu befürchten wären. Die Vorteile optischer Übertragung der Steuersignale sind die hohe EMV-Robustheit über lange Strecken. Dies gibt beispielsweise dem Hersteller eines Umrichters, welcher den Treiber verwenden will, Freiheiten für dessen Systemdesign.

Bekannt ist es, aktuelle Treiber zum Zwecke der optischen Ansteuerung über opto-elektronische Module mit dem optischen Ansteuersignal zu versorgen. Ein solches Modul ist z.B. aus der DE 101 51 113 B4 bekannt, umfasst eine Steckbuchse mit integrierter Photodiode und ggf. Verstärkerschaltung und wird auch als Steckbuchse bezeichnet. Die Steckbuchsen beinhalten nach Funktionalität einen optischen Ein- und einen elektrischen Ausgang oder umgekehrt und setzen Information zwischen den optischen und elektrischen Signalen um. Diese Sender- bzw. Empfängersteckbuchsen weisen zwei Nachteile auf: Der erste Nachteil sind zusätzliche Bauelemente auf der Platine. Der zweite Nachteil ist die schlechte EMV-Verträglichkeit einfacher Steckbuchsen. Bei dem bekannten Steckbuchsendesign besteht eine große Empfindlichkeit gegenüber elektromagnetischen Feldern im elektrischen Teil der Steckbuchse. Insbesondere die elektrischen Anschlusspins der Steckbuchsen bilden eine Fläche, in die magnetische Felder leicht ungewollte Ströme einkoppeln können. Diese elektrische Sensitivität zerstört die eigentlichen Vorteile einer EMV-unempfindlichen optischen Ansteuerung.

Aus dem Stand der Technik, offenbart in der DE 696 37 318 T2 ist eine einzelne Lichtempfangseinrichtung vom PIN-Typ bekannt, die in einem Informationsübertragungssystem verwendet wird. Die Lichtempfangseinrichtung und eine Vielfalt elektronischer Einrichtungen sind auf einem Träger monolithisch integriert. Diese Einrichtungen sind eine opto-elektronsiche Wandlerschaltung, eine fotoelektrische Transferschaltung und ein opto-elektronsiches Transfermodul.

Aus der EP 0 503 401 A1 ist eine lateral Fotosensoreinrichtung mit einer ersten Halbleiterschicht eines ersten Leitfähigkeitstyps auf einem Halbleitersubstrat bekannt. Eine zweite Halbleiterschicht eines zweiten Leitfähigkeitstyps ist auf der ersten Halbleiterschicht zum Absorbieren Licht ausgebildet. Diese Fotosensoreinrichtung ist mit einer integrierten optoelektronischen Wandlerschaltung verbunden.

Aufgabe der Erfindung ist es, einen verbesserten Treiber anzugeben.

Die Erfindung beruht auf der Erkenntnis, innerhalb des Treibers den bisherigen Steckbuchsen dadurch zu ersetzen, dass ein lichtempfindlicher Empfänger direkt in einen im Treiber verwendeten Halbleiterbaustein integriert wird und dass das Steuersignal führende Licht dann direkt in den Halbleiterbaustein eingestrahlt wird. Die Signalumsetzung optisch-elektrisch findet dann im Treiber innerhalb des Halbleiterbausteins statt. Die Erfindung beruht weiterhin auf der Erkenntnis, dass jeder Teil eines Halbleiterbausteins, ob Transistor, MOSFET (metal oxide semiconductor field effect transistor) oder Diode physikalisch bedingt lichtempfindlich ist, wenn er nicht lichtdicht abgedeckt wird.

Die Aufgabe der Erfindung wird daher gelöst durch einen Halbleiterbaustein für einen Treiber gemäß Patentanspruch 1 und einen Treiber gemäß Patentanspruch 8.

Der erfindungsgemäße Halbleiterbaustein für einen, einen Leistungshalbleiterschalter ansteuernden Treiber weist mehrere integrierte Schaltungsmodule auf. Der Halbleiterbaustein weist außerdem eine Kommunikationsschnittstelle auf, die einen optisch-elektrischen Empfänger enthält, d.h. einen Empfänger mit optischem Eingang und elektrischem Ausgang. Letzterer ist von das Steuersignal führendem Licht bestrahlbar und erzeugt hieraus ein elektrisches Ausgangssignal. Das in Rede stehende Steuersignal ist z.B. das Ansteuersignal für den Leistungshalbleiter. Der Empfänger weist ein lichtempfindliches Empfangsgebiet auf. Dieses liegt soweit an der für Licht zugänglichen Oberfläche des Empfängers, dass das einfallende Licht dort detektierbar und in ein elektrisches Signal umsetzbar ist. Die Oberfläche des Empfangsgebietes wird im folgenden als Empfangsfläche bezeichnet und steht auch stellvertretend für das gesamte Empfangsgebiet. Der Empfänger ist als eines der Schaltungsmodule im Halbleiterbaustein integriert. Die Integration erfolgt dabei derart, dass die Empfangsfläche vom Außenraum des Halbleiterbausteins her für das diesen bestrahlende Licht optisch zugänglich ist.

Die im Halbleiterbaustein integrierten Schaltungsmodule dienen unter anderem der Überwachung des Leistungshalbleiters, der Pulsformung im Ansteuersignal, der Fehlerverarbeitung, der Interlocksteuerung und ggf. weiteren Funktionen. Ein entsprechender Halbleiterbaustein bietet sich insbesondere für die Sekundärseite eines Treibers, beispielsweise die TOP-Ansteuerung in einer Halbbrücke an. Über das signalführende Licht kann eine direkte Ansteuerung des Empfängers auf sekundärseitigem Potential erfolgen, wenn der Halbleiterbaustein im Treiber im Bereich dieses Potentials angeordnet ist. Die Umsetzung der im einfallenden Licht als Steuersignal gespeicherten Schaltinformation oder sonstigen Information, welche an den Halbleiterbaustein beziehungsweise dessen Empfänger zu übermitteln ist, wird vom integrierten Empfänger in ein elektrisches Ausgangssignal umgesetzt, um sodann im Halbleiterbaustein weiterverarbeitet werden zu können. Das Licht, welches beispielsweise aus einem Lichtleiter austritt, um den Empfänger zu bestrahlen, muss nicht erst in den Steckbuchsen gelangen, sondern wird direkt auf den Halbleiterbaustein geleitet und dort umgesetzt. Der Halbleiterbaustein selbst ist hierbei wesentlich weniger EMV-anfällig als die bekannte Steckbuchse. Die elektromagnetische Störeinkopplung bei der optisch-elektrischen Signalwandlung wird drastisch reduziert. Im Halbleiterbaustein ergibt sich ein optischer Detektor mit hoher Störsicherheit im optisch-elektrischen Empfänger.

Steckbuchsen sind dann zumindest treiberseitig nicht mehr erforderlich. Damit entfallen zirka 50% der Kosten, da ein Benutzer des Treibers die optischen Steckbuchsen (hier in der Ausprägung als Sender) nur noch auf der signalsendenden, in der Regel primärseitigen Kontrollplatine benötigt, welche dann über Lichtwellenleiter den Treiber ansteuert. Bisher war dieselbe Anzahl von Steckbuchsen nochmals auf dem sekundärseitigen Treiber nötig.

So entsteht ein EMV-robustes Ansteuersystem, da die optischen Signale direkt auf den Halbleiterbaustein gelangen und dort zu einem eindeutigen elektrischen Signal in Form des Ausgangssignals umgesetzt werden. Mit den Steckbuchsen fallen auch die entsprechenden Flächen weg, in die EMV-Störsignale eingekoppelt werden könnten. Auf der Ansteuer- beziehungsweise Controllerseite kann ein Benutzer weiterhin Steckbuchsen verwenden, da die Controllerplatine in der Regel in einer weit weniger elektromagnetisch kritischen Umgebung platziert ist.

In einer bevorzugten Ausführungsform weist der Halbleiterbaustein ein Abdeckelement auf, welches zwar die Empfangsfläche frei lässt, jedoch die restliche Oberfläche des Halbleiterbausteins gegen einfallende Strahlung abdunkelt. Wenn nicht die gesamte restliche Oberfläche, so ist zumindest der Teil der Oberfläche abzudunkeln, auf welchem ein unerwünschter Strahlungseinfall möglich ist. In bevorzugter Weise ist das Abdeckelement eine Metallisierungsebene. Die Abdunkelung der nicht als lichtsensitiv gedachten Stellen des Halbleiterbausteins sollte aus praktischen Gründen in der obersten Metalllage erfolgen. Eine durchgehende Metallfläche in unteren Metalllagen würde normalerweise eine Erhöhung der mechanischen Spannung am Halbleiterbaustein beziehungsweise Chip bedeuten. Die oberen Lagen dagegen können vom Chip bzw. prozessierten Substrat durch Dotierung auf Fließfähigkeit und niedrigen Schmelzpunkt optimiertes Glas getrennt und meist auch aus weniger sprödem Metall gebaut sein. Zudem sind Lagen über einer geschlossenen Metallfläche nicht mehr für die Verdrahtung des Chips zu verwenden. Diese Lage ist also prädestiniert für eine Abdunkelung.

In einer besonderen Ausführungsform ist das Abdeckelement ein gegen das zur Signalübertragung verwendete Licht, insbesondere sichtbares Licht, abdunkelndes Abdeckelement. Insbesondere unbeabsichtigte Einkopplung von sichtbarem Licht ist besonders störend. Dagegen ist beispielsweise einkoppelnde Infrarotstrahlung in der Regel - zum Beispiel thermisch bedingt - gleichmäßig verteilt und daher weniger störend als unbeabsichtigt lokal eingestrahltes sichtbares Licht.

Bekannt ist es, Licht zur Ansteuerung eines Halbleiterbausteins mittels einer LED (Leuchtdiode) zu erzeugen, die wenige Prozent an Wirkungsgrad besitzt. Zudem geht durch Alterung und die Lichtwellenleiter Energie verloren, so dass am Empfänger nur noch relativ wenig Licht eintrifft.

Zusätzlich wird in der Regel ein Standard-CMOS-Fertigungsprozess zur Produktion des Halbleiterbausteins verwendet. Das eingestrahlte Licht lässt dann Elektronen-Loch-Paare in einer bestimmten Tiefe im Chip entstehen, abhängig von der Frequenz des Lichtsenders. Die Raumladungszone der Bauteile in der lichtempfindlichen Zone des Chips liegt dann nicht immer in dieser optimalen Tiefe, in der die Elektronen erzeugt werden. Der Wirkungsgrad eines Empfängers liegt daher im ein- bis unteren zweistelligen Prozentbereich. Der Empfänger muss also sehr niedrige Ströme detektieren können. Da die Empfangsfläche jedoch gleichzeitig relativ großflächig ist, ist es relativ einfach, in den Empfänger Störsignale in Form hoher Störpegel einzukoppeln. Hieraus folgt dessen geringe Störsicherheit.

Die Logikschaltung arbeitet insbesondere digital. Auch der optisch-elektrische Empfänger arbeitet in der Regel digital, d.h. er gibt als Ausgangssignal nur eine logische Eins oder Null aus. Das signalführende Licht besitzt dann ebenso nur zwei Zustände, d.h. das Vorhandensein ("Eins", Licht) oder Nichtvorhandensein ("Null", kein Licht, Dunkelheit) von signalführendem Licht.

Zudem wird die Störsicherheit des Empfängers auch dadurch eingeschränkt, dass der genaue Pegel, der die Abwesenheit von Licht, also einen "Dunkel"-Zustand anzeigt, über die Temperatur und Fertigungstoleranzen schwankt. Eine Schaltschwelle für die Entscheidung, ob an den Empfänger Licht eingekoppelt wird oder nicht (signalführendes Licht) muss daher möglichst fehlertolerant ausgelegt werden.

Um eine gewisse mechanische Toleranz bei der Ausrichtung des einstrahlenden Lichts auf die Empfangsfläche zuzulassen, ist es zielführend, die Empfangsfläche größer auszuführen, als der zu erwartende Lichtstrahl an Durchmesser aufweist, beziehungsweise dieser an Fläche mit Licht bestrahlt. Wird nun jedoch von der zur Verfügung stehenden Sensorfläche, d.h. Empfangsfläche beispielsweise nur die Hälfte beleuchtet, bedeutet dies aber nur die halbe Signalstärke am Empfänger bei gleicher Fläche. Dies führt zu einer Halbierung der Störsicherheit.

In einer bevorzugten Ausführungsform der Erfindung enthält der Empfänger daher eine Mehrzahl von Lichtsensoren. Jeder dieser Lichtsensoren arbeitet jeweils für sich eigenständig. Das heißt, jeder der Lichtsensoren erzeugt aus einfallendem Licht (oder Dunkelheit) ein eindeutiges elektrisches Ausgangssignal. Die Empfangsfläche besteht dann aus einer Mehrzahl von Teilflächen. Jedem Lichtsensor ist mindestens eine der Teilflächen zugeordnet. Eine Mehrzahl bedeutet im oberen Zusammenhang mindestens zwei, in der Regel jedoch mehrere, z.B. vier, neun oder zwölf oder auch andere Anzahlen von Lichtsensoren oder Teilflächen. Die Zuordnung kann beispielsweise in Einzelpaaren bestehen, so dass tatsächlich jedem Lichtsensor genau eine Teilfläche zugeordnet ist. Hier sind jedoch auch andere Gruppierungen denkbar, beispielsweise, dass einem Lichtsensor mehrere der Teilflächen zugeordnet sind.

Durch die Aufteilung der Sensorfläche in eine Mehrzahl von einzelnen Lichtsensoren kann jeder der Lichtsensoren wiederum so eingestellt werden, dass er erst dann auf einfallendes Licht reagiert, wenn er vollständig beleuchtet ist. Für den einzelnen Lichtsensor ergibt sich so wiederum ausreichende Störsicherheit. Mit anderen Worten erfolgt eine Aufteilung des Sensors in mehrere Einzelsensoren und deren logische Verschaltung.

In einer bevorzugten Variante dieser Ausführungsform erzeugen also die Lichtsensoren jeweils ein eigenes elektrisches Empfangssignal. Der Halbleiterbaustein weist dann zusätzlich eine Logikschaltung auf, welche die Empfangssignale logisch zum Ausgangssignal verknüpft. Mit anderen Worten wird eine Elektronik- beziehungsweise Logikschaltung den jeweiligen einzelnen Lichtsensoren nachgeschaltet, die beispielsweise erst dann reagiert, wenn die Hälfte der Lichtsensoren den Empfang von aktivem Licht, also logische "Eins" ausgeben. Die logische Verschaltung wirkt sich positiv auf die Störsicherheit aus. Der eigentliche Empfänger besteht dann aus jeweiligen Teil-Lichtsensoren mit voller Störsicherheit.

In einer weiteren bevorzugten Ausführungsform der Erfindung ist zwischen zwei Teilflächen ein Trennbereich angeordnet, der die Teilflächen voneinander beabstandet. Insbesondere befinden sich Trennbereiche zwischen allen, d.h. jeweils paarweise zwischen sämtlichen Teilflächen, so dass jede der Teilflächen von der jeweils anderen getrennt ist.

In einer Variante dieser Ausführungsform ist auf dem Trennbereich eine Trennwand angeordnet, welche sich von der Empfangsfläche weg zum Außenraum des Halbleiterbausteins hin erhebt. Insbesondere sind auf allen Trennbereichen derartige Trennwände errichtet. Jeder Sensor ist dann von jeweiligen Trennwänden auf allen Seiten umgeben. Die so entstehenden erhabenen Strukturen beziehungsweise Trennwände können auch mit anderen Worten die Trennbereiche vollständig ausfüllen.

In einer bevorzugten Variante dieser Ausführungsform sind auf dem Trennbereich, insbesondere auf den Trennwänden oder innerhalb von diesen, elektrische Leitelemente angeordnet. Insbesondere ergibt sich aus der Verbindung sämtlicher elektrischer Leitelemente zwischen sämtlichen Sensoren ein elektrisch leitfähiges Schirmgitter, welches die gesamte Empfangsfläche durchzieht beziehungsweise sich beabstandet und erhaben über dieser befindet. Die Leitelemente sind insbesondere wieder die oben genannten Metallflächen in Form einer obersten Metalllage auf dem Halbleiterbaustein. Mit anderen Worten wird oberhalb der Empfangsfläche ein elektrisch leitfähiges Gitter hergestellt, welches einen faradayschen Käfig bildet. Elektrisch leitfähige Gitter beziehungsweise die Leitelemente sind insbesondere mit der als Abdeckelement implementierten obersten Metalllage elektrisch verbunden.

Die o.g. oberste Metalllage des Chips ist aus den o.g. Gründen auch prädestiniert für ein Abschirmgitter gegen EMV. Im Idealfall sind die Öffnungen im Gitter hierzu kleiner als der Abstand zum Chip und ist die Abdunkelung am Metall an so vielen Stellen wie möglich an das Substrat angebunden, um einen idealen faradayschen Käfig zu bilden.

In einer weiteren bevorzugten Ausführungsform der Erfindung ist eines der Schaltungsmodule ein dem Empfänger gleichender Referenzempfänger. Die Empfangsfläche des Referenzempfängers ist gegen das signalführende Licht vollständig abgedunkelt. Insbesondere befindet sich der Referenzempfänger in der oben genannten abgedunkelten Zone des Chips außerhalb der Empfangsfläche des Empfängers. Mit dem Referenzempfänger ist eine Vergleichsmessung zum Empfänger möglich, um zu jedem Zeitpunkt eine Dunkelschwelle für den in der Regel baugleichen beziehungsweise die gleichen Charakteristiken aufweisenden Empfänger zu ermitteln. Mit anderen Worten wird ein Vergleichssensor im abgedunkelten Bereich des Halbleiterbausteins geschaffen. Temperatur, Alterung und Fertigungstoleranzen sowie die Betriebsspannung sind normalerweise auf dem gesamten Halbleiterbaustein beziehungsweise Chip konstant. Jeder abgedunkelte Referenzempfänger kann daher zur Ermittlung dienen, welches Ausgangssignal, insbesondere beispielsweise welche Spannung der tatsächliche Empfänger liefern würde, wenn eben gerade kein Lichteinfall des signalführenden Lichts stattfindet. Der Referenzempfänger kann hierbei von seinen mechanischen Dimensionen deutlich kleiner als der Empfänger ausgeführt sein, da der Referenzempfänger nicht großflächig Licht einfangen können muss.

In einer bevorzugten Ausführungsform ist der Halbleiterbaustein ein ASIC.

Der erfindungsgemäße Treiber weist einen oben genannten Halbleiterbaustein gemäß der Erfindung auf sowie eine dem Halbleiterbaustein zugeordnete mechanische Halterung für einen das signalführende Licht bereitstellenden Lichtleiter. Die Halterung ist hierbei so ausgerichtet, dass bei eingelegtem Lichtleiter das Licht auf die Empfangsfläche des Halbleiterbausteins gerichtet ist.

Ein Lichtleiter wird dann nicht wie bisher, in einen EMVempfindlichen optisch-elektrischen Steckbuchsen des Treibers eingelegt, sondern in die zum Treiber gehörende, rein mechanische Halterung. Die mechanische Halterung kann insbesondere aus EMV-neutralem Material und in EMV-neutraler Weise gebildet sein, z.B. als Kunststoffclip, welche dann keinerlei EMV-Nachteile bietet. Der erfindungsgemäße Treiber ermöglicht daher durch ein innovatives mechanisches Treiberkonzept die direkte optische Ansteuerung des IGBT-Treibers. Die Steckbuchsen werden also durch die mechanische Halterung im Treiber ersetzt, die deutlich kostengünstiger ausführbar ist.

Für die Ausrichtung der Halterung sind verschiedenste Varianten denkbar. Die Halterung kann das Ende des Lichtleiters - bezüglich dessen Mittellängsachse gesehen - beispielsweise senkrecht zur Oberfläche des Halbleiterbausteins beziehungsweise der Empfangsfläche ausrichten. Der Lichtleiter kann auch schräg zur Empfangsfläche ausgerichtet werden. Hierbei kann insbesondere auch die Abschlussfläche des Lichtwellenleiters abgeschrägt werden.

In einer bevorzugten Ausführungsform der Erfindung ist die Halterung im Gehäuse des Treibers integriert. Mit anderen Worten bildet ein Teil des Gehäuses selbst die Halterung. Ein zusätzliches Bauteil als mechanische Halterung entfällt dann.

In einer weiteren bevorzugten Ausführungsform der Erfindung enthält der Treiber ein Lichtführungselement, welches das aus dem Lichtleiter austretende Licht zur Empfangsfläche hin umlenkt. Das Lichtführungselement ist hierbei insbesondere so angeordnet, dass es die Empfangsfläche im Treiber bedeckt. Das Lichtführungselement ist beispielsweise ein Spiegelelement, leitet das Licht also durch Reflektion um. Insbesondere ist das Lichtführungselement direkt auf den Halbleiterbaustein bzw. die Empfangsfläche aufgesetzt, um diese zu versiegeln, unter Umständen unter Zwischenschaltung von optischen Klebern oder ähnlichem.

Die Halterung ist dann insbesondere so ausgeführt, dass der Lichtwellenleiter zum Lichtführungselement hin ausgerichtet ist, und das Licht zunächst auf das Lichtführungselement trifft, welches schließlich das Licht auf die Empfangsfläche umleitet. Das Lichtführungselement ist beispielsweise ein kleiner Parabolspiegel, der entweder durch eine reflektive Beschichtung des Gehäuses oder durch einen im Gehäuse vorgesehenen Spiegel realisiert wird.

Das erfindungsgemäße Verfahren dient zur Herstellung eines Treibers mit einer weiteren Ausgestaltung des Lichtführungselements. Erfindungsgemäß wird dann in einem ersten Schritt zunächst das Lichtführungselement als eine verformbare Rohform am Treiber angebracht. Mit Hilfe eines Prägestempels oder anderer formgebender Verfahren wird die Rohform in eine Endform geprägt bzw. umgeformt. Die Endform ist dann als Prisma mit planen oder mindestens einer gekrümmten reflektiven oder diffraktiven Oberfläche ausgebildet.

In einer Variante des Verfahrens wird die noch ungeprägte Rohform direkt auf den Halbleiterbaustein bzw. die Empfangsfläche, unter Umständen wieder unter Zwischenschaltung eines optischen Klebers usw. aufgesetzt. Alternativ wird die Rohform am Treibergehäuse oder an der Treiberplatine aufgesetzt und dort verformt.

Für eine weitere Beschreibung der Erfindung wird auf die Ausführungsbeispiele der Zeichnungen verwiesen. Es zeigen, jeweils in einer schematischen Prinzipskizze:
Fig.1 einen Treiber als Blockschaltbild,
Fig.2 den Halbleiterbaustein aus Fig.1 im Querschnitt,
Fig.3 eine alternative Empfangsfläche in Draufsicht,
Fig.4 einen alternativen Halbleiterbaustein im Querschnitt,
Fig.5 einen alternativen Treiber im Querschnitt,
Fig.6 eine zu einem Lichtführungselement geprägte Rohform.

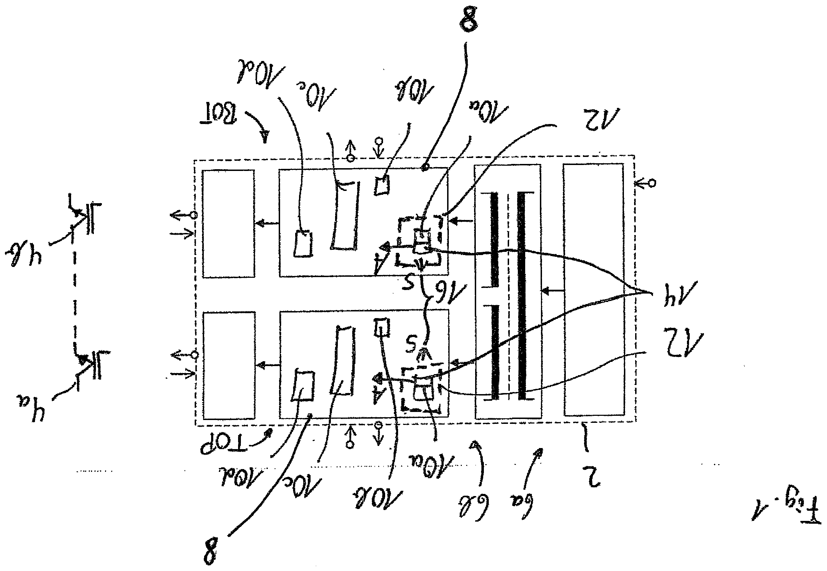

Fig. 1 zeigt einen Treiber 2 für eine Halbbrücke aus zwei seriell geschalteten Leistungshalbleiterschaltern 4a,b. Der Treiber 2 umfasst eine Primärseite 6a und eine hiervon potentialgetrennte Sekundärseite 6b. Der Halbbrücke sind sekundärseitige TOP- und BOT-Stufen zugeordnet. Der Treiber enthält neben nicht näher erläuterten Spannungssteuerungs- und Ausgangsstufen sowie einem Leistungsübertrager sowohl auf der TOP- als auch der BOT-Stufe jeweils einen Halbleiterbaustein 8a,b, hier in Form von ASICs. Insbesondere schalten diese die Leistungshalbleiterschalter 4a,b. Außerdem bewirken sie eine Schaltsignalverarbeitung wie auch eine Fehlerverarbeitung für die TOP- beziehungsweise BOT-Stufe. Am Treiber 2 sind außerdem nicht näher erläuterte Ein- und Ausgänge für Leistungsversorgung, Fehlersignale, Kollektor-Emitter-Spannung der Leistungshalbleiterschalter 4a,b und deren Ansteuersignale vorhanden.

Jeder der Halbleiterbausteine 8a,b weist mehrere integrierte Schaltungsmodule 10a-d auf, die zum Beispiel die oben genannte Signal- und Fehlerverarbeitung realisieren. Die Halbleiterbausteine 8a,b weisen außerdem jeweils eine Kommunikationsschnittstelle 12 auf, die einen optisch elektrischen Empfänger 14 enthält. Dieser ist von signalführendem Licht 16 bestrahlbar. Der Empfänger 14 erzeugt aus dem einfallenden Licht bzw. dem von diesem getragenen Schaltsignal S ein elektrisches Ausgangssignal A.

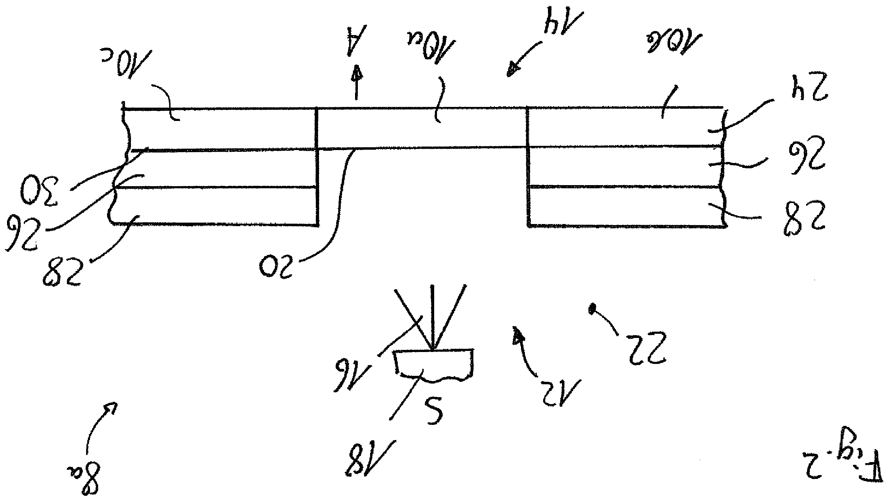

Fig. 2 zeigt einen Teil des Halbleiterbausteins 8a im Detail im Querschnitt. Sichtbar sind die Schaltungsmodule 10a-c. Das Schaltungsmodul 10a ist außerdem als Empfänger 14 der Kommunikationsschnittstelle 12 ausgeführt bzw. umgekehrt. Das Licht 16 tritt hier aus einem Lichtleiter 18 aus. Im Licht 16 ist das Steuersignal S digital codiert, wobei eine logische Eins dem Vorhandensein von Licht 16 und eine logische Null dessen Nichtvorhandensein entspricht. Der Empfänger 14 weist eine lichtempfindliche Empfangsfläche 20 auf. Die Empfangsfläche 20 ist hierbei vom Außenraum 22 des Halbleiterbausteins 8a her für das bestrahlende Licht 16 optisch zugänglich.

Dies ist dadurch erreicht, dass auf einem Substrat 24 des Halbleiterbausteins 8a zunächst eine Isolationsschicht 26, hier aus Siliziumdioxid (SiO₂) aufgebracht ist. Auf dieser ist wiederum ein Abdeckelement 28, im Beispiel eine oberste Metallisierungsebene, aufgebracht. Diese dunkelt bis auf die Empfangsfläche 20 die restliche Oberfläche 30 des Halbleiterbausteins 8a ab.

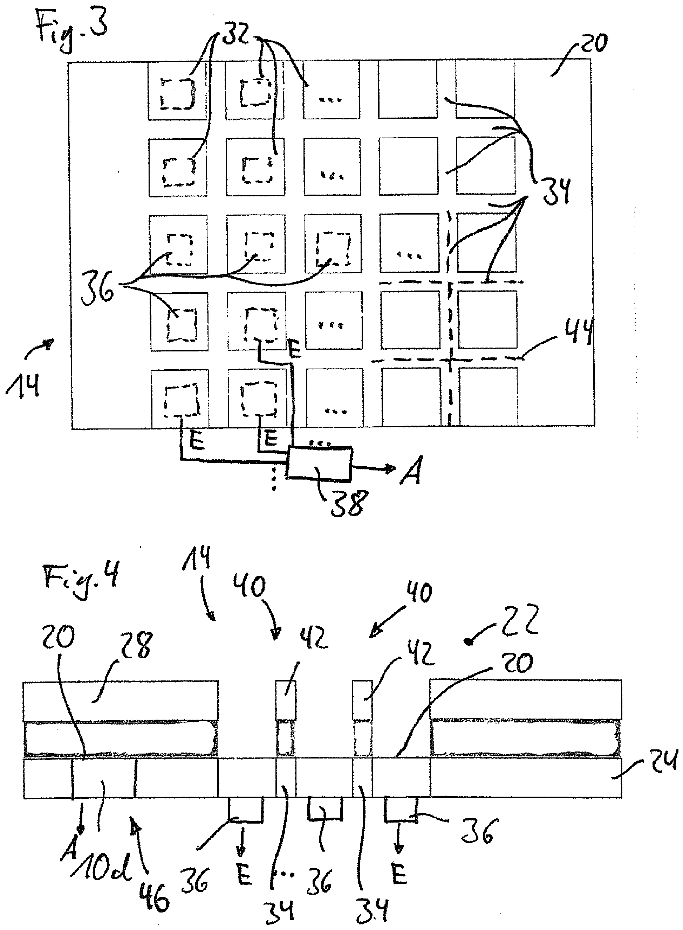

Fig. 3 zeigt einen alternativen Empfänger 14 beziehungsweise dessen Empfangsfläche 20 in Draufsicht. Bestimmte Elemente sind in dieser Figur nur in geringer Stückzahl angedeutet bzw. bezeichnet. Die Empfangsfläche 20 ist hier in eine Mehrzahl von, hier fünfundzwanzig, - hier gleiche - Teilflächen 32 aufgeteilt. Diese sind durch - hier ebenfalls gleiche - Trennbereiche 34 voneinander abgetrennt beziehungsweise beabstandet. Außerdem enthält der Empfänger 14 jeweils eigenständig für sich arbeitende, hier ebenfalls fünfundzwanzig gleiche Lichtsensoren 36. Im Beispiel ist jedem Lichtsensor 36 genau eine der Teilflächen 32 zugeordnet. Jeder der Lichtsensoren 36 erzeugt aus einfallendem Licht 16 bzw. dem Steuersignal S ein eigenes elektrisches Empfangssignal E. Der Halbleiterbaustein 8a enthält in dieser Ausführungsform zusätzlich eine Logikschaltung 38, welche sämtliche Empfangssignale E logisch zum Ausgangssignal A verknüpft. Insbesondere sind Steuersignal S, Ausgangssignal A und Empfangssignale E Binärsignale und die Logikschaltung 38 eine Binärlogik.

Fig. 4 zeigt einen alternativen, entsprechend Fig. 3 in mehrere, hier neun Lichtsensoren 36 aufgeteilten Empfänger 14 im Seitenschnitt. Hier sind auf den Trennbereichen 34 Trennwände 40 aufgesetzt, welche sich von der Empfangsfläche 20 zum Außenraum 22 hin erheben.

Auf den Trennbereichen 34 sind außerdem elektrische Leitelemente 42 angeordnet, welche sowohl untereinander als auch mit dem elektrisch leitfähigen Abdeckelement 28 elektrisch verbunden sind. Diese bilden damit ein Abschirmgitter 44, das eine EMV-Einstrahlung auf das Substrat 24 beziehungsweise die darin vorhandenen Schaltungsmodule 10a-d verhindert. Der prinzipielle Verlauf eines entsprechenden Abschirmgitters 44 ist nochmals in Fig. 3 für die dortige Ausführungsform gestrichelt angedeutet.

Fig. 4 zeigt außerdem, wie ein weiteres integriertes Schaltungsmodul 10d als Referenzempfänger 46 ausgebildet ist. Dieser weist ebenfalls eine Empfangsfläche 20 auf und erzeugt ein Ausgangssignal A. Der Referenzempfänger 46 gleicht dem Empfänger 14 insbesondere bezüglich seiner Charakteristik zur Umwandlung von Licht in das Ausgangssignal A. Das heißt, dass der Referenzempfänger 46 und der Empfänger 14 zumindest bei Fehlen von einstrahlendem Licht das prinzipiell gleiche Ausgangssignal A erzeugen. Insbesondere sind z.B. die Spannungspegel der beiden Signale dann im gewünschten Maße gleich. Der Referenzempfänger 46 befindet sich unter dem abdunkelnden Abdeckelement 28 und ist somit vor jeglichem Licht, insbesondere dem Licht 16 geschützt. Er liefert daher immer ein Ausgangssignal A für einen Dunkelwert, d.h. eine logische "Null". Dieses Signal dient dann als Referenzsignal bzw. Referenzpegel für die Auswertung des Lichts 16 im Empfänger 14.

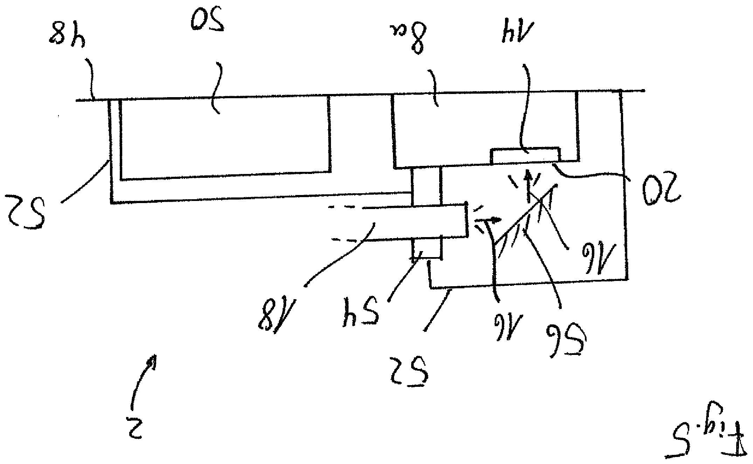

Fig. 5 zeigt einen Treiber 2, bei dem auf einer Leiterplatte 48 neben einem Transformator 50 auch der Halbleiterbaustein 8a mit dem Empfänger 14 und dessen Empfangsfläche 20 angeordnet ist. Der gesamte Treiber 2 ist hier von einem Gehäuse 52 bedeckt. Im Gehäuse 52 ist eine mechanische Halterung 54 für den Lichtleiter 18 vorgesehen. Bei eingelegtem Lichtleiter 18 ist das aus diesem austretende Licht 16 - ggf. mittels geeigneter Ablenkelemente - auf die Empfangsfläche 20 gerichtet. Die Halterung 54 ist hierbei im Gehäuse 52 integriert.

Im Treiber 2 ist außerdem als Beispiel für ein Ablenkelement ein Lichtführungselement 56, hier in Form eines Prismas mit planer reflektiver Oberfläche vorgesehen, welches das aus dem Lichtleiter 18 austretende Licht 16 zur Empfangsfläche 20 hin umlenkt.

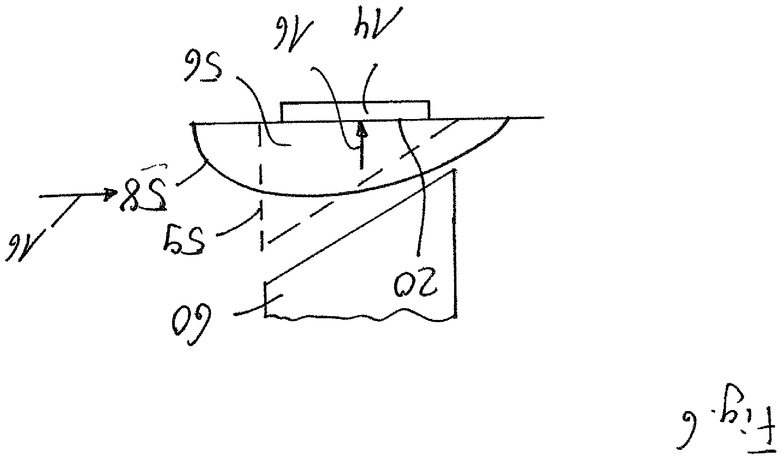

Fig. 6 zeigt, wie in einer Ausführungsform in einem ersten Verfahrensschritt auf die Empfangsfläche 20 eine verformbare Rohform 58 am Treiber 2, hier direkt am Halbleiterbaustein 8a, angebracht wird. Die Rohform 58 bedeckt damit die Empfangsfläche 20 und schützt diese zugleich vor Umwelteinflüssen. Im ersten Verfahrensschritt wird hierbei die Rohform 58 direkt auf dem Halbleiterbaustein 8a angeordnet. Die Rohform 58 ist als duro- oder thermoplastischer Kunststoff ausgebildet, der direkt auf die Empfängergrenzfläche 20 ausgebracht wird. Alternativ kann zwischen der Rohform 58 und der Empfangsfläche 20, hier der Empfängergrenzfläche, ein optischer Kleber vorgesehen sein.

In einem zweiten Verfahrensschritt wird nun mit Hilfe eines Prägestempels 60 oder anderen formgebenden Verfahren die Rohform 58 in eine Endform 59 geprägt und damit ein Ablenkelement, hier ein Prisma als Lichtführungselement 56 (gestrichelt dargestellt) erzeugt. So kann einfallendes Licht 16 durch Totalreflexion an der reflektierenden Fläche wieder auf die Oberfläche 20 umgelenkt werden.

## Patentansprüche

1. Halbleiterbaustein (8a,b) für einen, einen Leistungshalbleiterschalter (4a,b) ansteuernden Treiber (2), wobei der Halbleiterbaustein (8a, 8b) aufweist:
- mehrere integrierte Schaltungsmodulen (10a-d),
- eine Kommunikationsschnittstelle (12), die einen von ein Steuersignal (S) führendem Licht (16) bestrahlbaren, ein elektrisches Ausgangssignal (A) erzeugenden optisch-elektrischen Empfänger (14) enthält,
wobei der optisch-elektrische Empfänger (14) eine lichtempfindliche Empfangsfläche (20) aufweist,
wobei eines der Schaltungsmodule (10a) den optisch-elektrischen Empfänger (14) aufweist und derart im Halbleiterbaustein (8a,b) integriert ist, dass die Empfangsfläche (20) vom Außenraum (22) des Halbleiterbausteins (8a,b) her für das diese bestrahlende Licht (16) optisch zugänglich ist und
- wobei der optisch-elektrische Empfänger (14)eine Mehrzahl von jeweils für sich eigenständig arbeitenden Lichtsensoren (36) enthält, bei dem die Empfangsfläche (20) aus einer Mehrzahl von Teilflächen (32) besteht und hierbei jedem Lichtsensor (36) eine der Teilflächen (32) zugeordnet ist
- mit einer die jeweiligen eigenen Empfangssignale (E) jedes Lichtsensor logisch zum Ausgangssignal (A) verknüpfenden Logikschaltung (38), die erst dann reagiert, wenn die Hälfte der Lichtsensoren (36) den Empfang von aktivem Licht, also logische "Eins" ausgeben.

2. Halbleiterbaustein (8a,b) nach Anspruch 1, mit einem die Empfangsfläche (20) freilassenden und die restliche Oberfläche (30) des Halbleiterbausteins (8a,b) abdunkelnde Abdeckelement (28).

3. Halbleiterbaustein (8a,b) nach Anspruch 2, bei dem das Abdeckelement (28) ein gegen sichtbares Licht abdunkelndes Abdeckelement (28) ist.

4. Halbleiterbaustein (8a,b) nach Anspruch 1, mit einem zwischen zwei Teilflächen (32) angeordneten, diese beabstandenden Trennbereich (34).

5. Halbleiterbaustein (8a,b) nach Anspruch 4, mit einer auf dem Trennbereich (34) angeordneten, sich von der Empfangsfläche (20) zum Außenraum (22) hin erhebenden Trennwand (40).

6. Halbleiterbaustein (8a,b) nach einem der Ansprüche 4 oder 5, mit einem auf dem Trennbereich (34) angeordneten elektrischen Leitelement (42).

7. Halbleiterbaustein (8a,b) nach einem der vorhergehenden Ansprüche, bei dem eines der Schaltungsmodule (10b-d) ein dem Empfänger (14) gleichender Referenzempfänger (46) ist, dessen Empfangsfläche (20) gegen das das Steuersignal (S) führende Licht (16) abgedunkelt ist.

8. Treiber (2) mit einem Halbleiterbaustein (8a,b) nach einem der Ansprüche 1 bis 7, mit einer dem Halbleiterbaustein (8a,b) zugeordneten mechanischen Halterung (54) für einen das das Steuersignal (S) führende Licht (16) bereitstellenden Lichtleiter (18), die so ausgerichtet ist, dass bei eingelegtem Lichtleiter (18) das Licht (16) auf die Empfangsfläche (20) gerichtet ist.

9. Treiber (2) nach Anspruch 8, mit einem Gehäuse (52), bei dem die Halterung (54) im Gehäuse (52) integriert ist.

10. Treiber (2) nach einem der Ansprüche 8 bis 9, mit einem das Licht (16) auf die Empfangsfläche (20) des Empfängers (14) umlenkenden Lichtführungselement (56), das diese Empfangsfläche (20) bedeckend im Treiber (2) angeordnet ist.

## Claims

1. Semiconductor chip (8a, b) for a driver (2) controlling a power semiconductor switch (4a, b), wherein the semiconductor chip (8a, 8b) comprises:
- a number of integrated circuit modules (10a-d),
- a communication interface (12) which contains an opto-electrical receiver (14) which can be irradiated by light (16) carrying a control signal (S) and generates an electrical output signal (A),
- wherein the opto-electrical receiver (14) has a light-sensitive receiving area (20),
- wherein one of the circuit modules (10a) has the opto-electrical receiver (14) and is integrated in the semiconductor chip (8a, b) in such a manner that the receiving area (20) is optically accessible from the external space (22) of the semiconductor chip (8a, b) for the light (16) irradiating it, and
- wherein the opto-electrical receiver (14) contains a plurality of light sensors (36) in each case operating independently by themselves, in which the receiving area (20) consists of a plurality of part-areas (32) and thus one of the part-areas (32) is allocated to each light sensor (36),
- comprising a logic circuit (38) logically combining the respectively independent received signals (E) of each light sensor to form the output signal (A), which circuit responds only when half of the light sensors (36) output the reception of active light, that is to say a logical "one".

2. Semiconductor chip (8a, b) according to Claim 1, comprising a covering element (28) leaving the receiving area (20) exposed and darkening the remaining surface (30) of the semiconductor chip (8a, b).

3. Semiconductor chip (8a, b) according to Claim 2, in which the covering element (28) is a covering element (28) darkening against visible light.

4. Semiconductor chip (8a, b) according to Claim 1, comprising a separating area (34) arranged between two part-areas (32), spacing these apart.

5. Semiconductor chip (8a, b) according to Claim 4, comprising a partition (40) arranged on the separating area (34), rising from the receiving area (20) towards the external space (22).

6. Semiconductor chip (8a, b) according to either of Claims 4 and 5, comprising an electrical conducting element (42) arranged on the separating area (34).

7. Semiconductor chip (8a, b) according to one of the preceding claims, in which one of the circuit modules (10b-d) is a reference receiver (46) similar to the receiver (14), the receiving area (20) of which is darkened against the light (16) carrying the control signal (S).

8. Driver (2) comprising a semiconductor chip (8a, b) according to one of Claims 1 to 7, with a mechanical support (54), allocated to the semiconductor chip (8a, b), for a light guide (18) providing the light (16) carrying the control signal (S), which support is aligned in such a manner that with the light guide (18) inserted, the light (16) is directed to the receiving area (20).

9. Driver (2) according to Claim 8, comprising a housing (52) in which the support (54) is integrated in the housing (52).

10. Driver (2) according to either of Claims 8 and 9, comprising a light guiding element (56), diverting the light (16) to the receiving area (20) of the receiver (14), which is arranged covering this receiving area (20) in the driver (2).

## Revendications

1. Module à semi-conducteur (8a, b) pour un circuit d'attaque (2) activant un interrupteur à semi-conducteur de puissance (4a, b) le module à semi-conducteur (8a, 8b) comportant :
- plusieurs modules de circuits intégrés (10ad),
- une interface de communication (12) qui contient un récepteur optoélectronique (14) susceptible d'être irradié par une lumière (16) guidant un signal de commande (S), délivrant un signal de sortie (A) électrique,
le récepteur optoélectronique (14) comportant une surface réceptrice (20) photosensible, l'un des modules de circuits (10a) comportant le récepteur optoélectronique (14) et étant intégré dans le module à semi-conducteur (8a, b), de sorte que la surface réceptrice (20) soit optiquement accessible à partir de l'espace extérieur (22) du module à semi-conducteur (8a, b) par la lumière (16) irradiant celui-ci et
- le récepteur optoélectronique (14) contenant une pluralité de capteurs de lumière (36) fonctionnant chacun pour soi de manière autonome, sur lesquels la surface réceptrice (20) est constituée d'une pluralité de surfaces partielles (32) et à cet effet, l'une des surfaces partielles (32) étant associée à chaque capteur de lumière (36)
- avec un circuit logique (38) connectant logiquement les signaux de réception (E) respectivement propres à chaque capteur de lumière avec le signal de sortie (A), qui ne réagit qu'une fois que la moitié des capteurs de lumière (36) délivrent la réception de lumière active, donc un « un » logique.

2. Module à semi-conducteur (8a, b) selon la revendication 1, avec un élément de recouvrement (28) laissant libre la surface réceptrice (20) et occultant la surface restante (30) du module à semi-conducteurs (8a, b)

3. Module à semi-conducteur (8a, b) selon la revendication 2, dans lequel l'élément de recouvrement (28) est un élément de recouvrement (28) occultant la lumière visible.

4. Module à semi-conducteur (8a, b) selon la revendication 1, avec une zone de séparation (34) placée entre deux surfaces partielles (32), écartant ces dernières.

5. Module à semi-conducteur (8a, b) selon la revendication 4, avec une paroi de séparation (40) placée sur la zone de séparation (34) s'élevant de la surface réceptrice (20) vers l'espace extérieur (22).

6. Module à semi-conducteur (8a, b) selon l'une quelconque des revendications 4 ou 5, avec un élément conducteur électrique (42) placé sur la zone de séparation (34).

7. Module à semi-conducteur (8a, b) selon l'une quelconque des revendications précédentes, sur lequel l'un des modules de circuits (10b à d) est un récepteur de référence (46) ressemblant au récepteur (14), dont la surface réceptrice (20) est occultée à l'encontre de la lumière (16) guidant le signal de commande (S).

8. Circuit d'attaque (2) avec un module à semi-conducteur (8a, b) selon l'une quelconque des revendications 1 à 7, avec une fixation mécanique (54) associée au module à semi-conducteur (8a, b) pour un guide de lumière (18) mettant à disposition la lumière (16) guidant le signal de commande (S), qui est alignée de la sorte que lorsque le guide de lumière (18) est inséré, la lumière (16) soit dirigée sur la surface réceptrice (20).

9. Circuit d'attaque (2) selon la revendication 8, avec un boîtier (52), dans lequel la fixation (54) est intégrée dans le boîtier (52).

10. Circuit d'attaque (2) selon l'une quelconque des revendications 8 à 9, avec un élément guide de lumière (56) renvoyant la lumière (16) sur la surface réceptrice (20) du récepteur (14) qui est placée de manière couvrante sur ladite surface réceptrice (20) dans le circuit d'attaque (2).
